# EUROPÄISCHE PATENTANMELDUNG

(11) **EP 1 811 272 A2**
(43) Veröffentlichungstag der Anmeldung: **25.07.2007**
(21) Anmeldenummer: 07100749.6
(22) Anmeldetag: 18.01.2007
(51) Int. Cl.: G01D 11/24, H03K 17/95

(54) **Sensorvorrichtung**

(30) Priorität: 24.01.2006 DE 102006003993
(71) Anmelder: BALLUFF GmbH, 73765 Neuhausen (DE)
(72) Erfinder: Dr. Jagiella, Manfred, 73274, Notzingen (DE); Kunzweiler, Winfried, 73061, Ebersbach-Bünzwangen (DE); Dr. Matter, Urs, 4500, Solothurn (CH); Mahler, Simon, 3013, Bern (CH)
(74) Vertreter: Hoeger, Stellrecht & Partner Patentanwälte

(57) **Zusammenfassung**

Es wird eine Sensorvorrichtung, umfassend ein Sensormodul mit einem Gehäuse, mit mindestens einem Sensorelement, welches in dem Gehäuse angeordnet ist, mit mindestens einer aktiven Sensorfläche und mit einer Sensormodul-Anschlusseinrichtung und ein Haltemodul zum Halten des Sensormoduls, mit einer Haltemodul-Anschlusseinrichtung, welche an die Sensormodul-Anschlusseinrichtung angepasst ist, vorgeschlagen, wobei über die Sensormodul-Anschlusseinrichtung und die Haltemodul-Anschlusseinrichtung das Sensormodul an dem Haltemodul fixierbar ist und eine elektrische Verbindung zwischen dem Sensormodul und dem Haltemodul bereitstellbar ist, und wobei das Haltemodul zur Fixierung an einer Anwendung vorgesehen ist oder Teil einer Anwendung ist, die Energieversorgung des Sensormoduls über das Haltemodul erfolgt und die Signalauskopplung über das Haltemodul erfolgt.

## Beschreibung

Die Erfindung betrifft eine Sensorvorrichtung.

Die Erfindung betrifft ferner eine induktive Sensorvorrichtung, umfassend eine Spule als Sensorelement und ein Gehäuse, in welchem die Spule angeordnet ist, wobei das Gehäuse eine erste Gehäusestirnseite aufweist, durch welche eine aktive Sensorfläche bestimmt ist, und eine gegenüberliegende zweite Gehäusestirnseite aufweist.

Die Erfindung betrifft ferner eine induktive Sensorvorrichtung mit einer Sensoreinheit, umfassend ein Gehäuse und mindestens ein induktives Sensorelement, welches in dem Gehäuse angeordnet ist.

Aus der DE 101 46 157 A1 ist ein Sensor bekannt, welcher ein Impulsgeberrad, einen Klemmenverbinder, der eine Schweißfläche aufweist, und ein Messaufbaugehäuse, das neben das Impulsgeberrad gestellt ist und eine Schweißfläche aufweist, umfasst, wobei die Schweißfläche des Messaufbaugehäuses mit der Schweißfläche des Klemmenverbinders durch ein Ultraschallschweißverfahren verbunden ist.

Aus der DE 196 20 548 C2 ist eine Magnetfeld-Sensoranordnung mit einem topfartigen Gehäuse, bei dem das eine Ende einer zylindrischen Wandung eine Montageöffnung aufweist und das andere Ende durch eine einstückig angeformte Vorderwand geschlossen ist, mit einem Sensorchip, bei dem ein Hall-Generator und die vorderen Ende von Anschlussdrähten in einem Schutzkörper eingebettet sind, und mit einem stabförmigen Permanentmagneten bekannt. Der Schutzkörper ist im Wesentlichen quaderförmig ausgebildet und von einer Vorderfläche und einer dazu parallelen Hinterfläche sowie je zwei gegenüberliegenden Seitenflächen begrenzt, wobei alle Anschlussdrähte aus einer Seitenfläche austreten und nach rechtwinkliger Abbiegung senkrecht zur Hinterfläche und von dieser weg weisend verlaufen. Die Vorderwand des Gehäuses weist ein auf die Form des Schutzkörpers abgestimmtes Fenster auf, in das der Schutzkörper von innen derart einsetzbar ist, dass eine Vorderfläche um einen bestimmten Betrag gegenüber der Vorderwand nach außen vorsteht. Es ist eine Hinterwand vorgesehen, die eine Ausnehmung für den Durchtritt der Anschlussdrähte aufweist und mit der die Montageöffnung des Gehäuses verschließbar ist.

Aus der WO 01/65694 A2 ist ein Näherungssensor mit Sensorkopf zur Erzeugung von Sensorsignalen bekannt, welcher in einen den Sensorkopf enthaltenden Befestigungsabschnitt und einen hiermit verbindbaren Elektronikabschnitt aufgeteilt ist. Der Elektronikabschnitt weist eine Sensorsignal-Auswerteeinheit und eine Energieversorgung auf, wobei die Sensorsignale über elektrische Kontakte oder kontaktlos vom Befestigungsabschnitt zum Elektronikabschnitt gelangen.

Aus der DE 197 55 924 A1 ist ein elektronisches Auswertegerät zur Erfassung und/oder Überwachung von Impulsen mit einem Gehäuse, mit einer Auswerteelektronik und mit einer Anzeigeeinrichtung bekannt, wobei die Impulse von einer berührungslos arbeitenden Sensorik erzeugt werden und das Auswertegerät mindestens einen potentialfreien Relaisausgang aufweist. Die Sensorik ist im Auswertegerät integriert.

Aus der US 3,719,898 und der US 4,757,213 sind ebenfalls Näherungsschalter bekannt.

Der Erfindung liegt die Aufgabe zugrunde, eine Sensorvorrichtung bereitzustellen, welche universell einsetzbar ist.

Diese Aufgabe wird erfindungsgemäß dadurch gelöst, dass ein Sensormodul mit einem Gehäuse, mit mindestens einem Sensorelement, welches in dem Gehäuse angeordnet ist, mit mindestens einer aktiven Sensorfläche und mit einer Sensormodul-Anschlusseinrichtung vorgesehen ist, und ein Haltemodul zum Halten des Sensormoduls, mit einer Haltemodul-Anschlusseinrichtung, welche an die Sensormodul-Anschlusseinrichtung angepasst ist, vorgesehen ist, wobei über die Sensormodul-Anschlusseinrichtung und die Haltemodul-Anschlusseinrichtung das Sensormodul an dem Haltemodul fixierbar ist und eine elektrische Verbindung zwischen dem Sensormodul und dem Haltemodul bereitstellbar ist, und wobei das Haltemodul zur Fixierung an einer Anwendung vorgesehen ist oder Teil einer Anwendung ist, die Energieversorgung des Sensormoduls über das Haltemodul erfolgt und die Signalauskopplung über das Haltemodul erfolgt.

Bei der erfindungsgemäßen Lösung umfasst die Sensorvorrichtung (mindestens) zwei Teile, nämlich ein Sensormodul und ein Haltemodul. Das Sensormodul bildet die Detektionseinheit der Sensorvorrichtung. Das Haltemodul bildet die "Versorgungseinheit" für das Sensormodul. Über das Haltemodul erfolgt die mechanische Fixierung an einer Anwendung, es erfolgt die Bereitstellung von elektrischer Energie zum Betrieb des Sensormoduls und die Auskopplung von Sensorsignalen erfolgt über das Haltemodul.

Das Haltemodul lässt sich auf einfache Weise herstellen. Es muss nicht mit einer elektronischen Schaltung versehen werden. Beispielsweise umfasst es eine Montageeinrichtung zur Fixierung an einer Anwendung. Ferner muss für eine elektrische Verbindung einer externen Energieversorgung und einer Signalleitung der Haltemodul-Anschlusseinrichtung gesorgt werden. Über die Haltemodul-Anschlusseinrichtung wiederum lässt sich das Sensormodul auch mechanisch fixieren.

In der Praxis werden je nach Anwendung unterschiedliche Anforderungen bezüglich der Montage einer Sensorvorrichtung gestellt. Durch die erfindungsgemäße Lösung lässt sich ein Typ von Sensormodul oder eine kleine Anzahl von Sensormodulen-Typen bereitstellen, wobei die Variabilität bezüglich der Fixierbarkeit an einer Anwendung über die Haltemodule erfolgt. Ein Haltemodul wird entsprechend den Anwendungserfordernissen ausgebildet, wobei das oder die kleine Anzahl von Sensormodulen bei allen Anwendungen einsetzbar sind. Die Sensormodule lassen sich dann auf einfache und kostengünstige Weise herstellen und auch lagern. Weiterhin lassen sich die Sensormodule dann auch kompakt und mit kleinen Abmessungen ausbilden.

Insbesondere ist ein Sensormodul lösbar mit einem Haltemodul verbindbar. Dadurch ist auf einfache Weise ein Sensormodulaustausch ermöglicht, ohne dass das Haltemodul an einer Anwendung ausgetauscht werden muss.

Insbesondere sind die Sensormodul-Anschlusseinrichtung und die Haltemodul-Anschlusseinrichtung so ausgebildet, dass das Sensormodul auf das Haltemodul aufsteckbar ist. Dadurch ergibt sich eine einfache Verbindbarkeit zwischen dem Sensormodul und dem Haltemodul, durch welche für eine elektrische Verbindung (bezüglich elektrischer Energieversorgung und Signalauskopplung) gesorgt ist sowie eine mechanische Verbindung zur Fixierung des Sensormoduls an dem Haltemodul gesorgt ist. Es lässt sich dadurch auf einfache Weise eine lösbare Verbindung realisieren, so dass ein Sensormodul auch auf einfache Weise austauschbar ist.

Besonders günstig ist es, wenn die Sensormodul-Anschlusseinrichtung mindestens einen Stift aufweist und die Haltemodul-Anschlusseinrichtung eine angepasste Stiftaufnahme aufweist. Eine Stift-Stiftaufnahmen-Verbindung lässt sich auf einfache Weise herstellen. Es lässt sich eine mechanisch stabile Verbindung erreichen, durch die gleichzeitig auch eine elektrische Verbindung hergestellt werden kann.

Aus dem gleichen Grund ist es günstig, wenn die Haltemodul-Anschlusseinrichtung mindestens einen Stift aufweist und die Sensormodul-Anschlusseinrichtung mindestens eine angepasste Stiftaufnahme aufweist.

Ganz besonders vorteilhaft ist es, wenn der mindestens eine Stift als Kontaktstift ausgebildet ist. Es lässt sich dann auf einfache Weise ein Sensormodul auf ein Haltemodul aufstecken, wobei automatisch für eine elektrische Verbindung und für eine mechanische Verbindung gesorgt ist.

Insbesondere sind mindestens zwei Stifte vorgesehen. Ein Stift dient für die Weitergabe von Sensorsignalen an das Haltemodul. Ein oder zwei weitere Stifte dienen für die elektrische Energieversorgung. (Im Falle einer Zwei-Stifte-Lösung kann die Sensorsignalweitergabe und die Energieversorgung auf den gleichen Stift fallen.) Es kann beispielsweise auch ein vierter Stift vorgesehen sein für ein Überwachungssignal. Grundsätzlich ist es möglich, dass die Anzahl der Stiftaufnahmen genau der Anzahl der Stifte entspricht. Es ist beispielsweise auch möglich, dass die Anzahl der Stiftaufnahmen größer ist als die Mindestanzahl an Stiften. Dadurch lassen sich alle Arten von Sensormodulen an dem entsprechenden Haltemodul fixieren. Beispielsweise weist ein Haltemodul vier Stiftaufnahmen auf. Dadurch lassen sich dann Sensormodule mit zwei oder drei Kontaktstiften und mit vier Kontaktstiften an dem entsprechenden Haltemodul fixieren; es lassen sich so beispielsweise Sensormodule mit interner Überwachung oder ohne interne Überwachung an dem Haltemodul fixieren.

Günstig ist es, wenn das Haltemodul eine Montageeinrichtung zur Fixierung an einer Anwendung aufweist. Dadurch lässt sich das Haltemodul mechanisch an einer Anwendung positionieren und fixieren.

Bei einer Ausführungsform umfasst die Montageeinrichtung mindestens eine durchgehende Ausnehmung. Die durchgehende Ausnehmung liegt beispielsweise in Form einer Bohrung vor. Dadurch lässt sich die Montageeinrichtung und damit das Haltemodul beispielsweise über Schrauben an der Anwendung fixieren.

Eine Orientierungsrichtung der mindestens einen Ausnehmung kann parallel und/oder quer (insbesondere senkrecht) zu einer Aufsteckrichtung des Sensormoduls auf das Haltemodul sein. Je nach Anwendung lassen sich dadurch unterschiedliche Ausrichtungen des Sensormoduls und auch von aktiven Flächen des Sensormoduls bezogen auf die Anwendung realisieren.

Es ist beispielsweise auch möglich, dass die Montageeinrichtung ein Gewinde umfasst. Dadurch lässt sich das Haltemodul an einer Anwendung einschrauben bzw. über eine oder mehrere Muttern, welche an dem Gewinde geführt sind, an einer Anwendung einspannen.

Bei einer Ausführungsform umfasst die Montageeinrichtung ein klemmbares Element und/oder mindestens ein klemmendes Element. Dadurch kann die Montageeinrichtung an einer Anwendung eingespannt werden bzw. sie stellt selber Klemmelemente bereit, um die Montageeinrichtung klemmend an einer Anwendung halten zu können.

Es kann vorgesehen sein, dass die Montageeinrichtung eine Stange umfasst. Eine solche Stange ist mindestens teilweise umgreifbar, um sie an einer Anwendung zu fixieren. Dadurch lässt sich das Haltemodul beispielsweise an einer Stativanordnung auf einfache Weise fixieren.

Es kann auch vorgesehen sein, dass das Haltemodul mehrteilig ausgebildet ist, wobei ein erstes Teil an einer Anwendung fixierbar ist und ein zweites Teil an dem ersten Teil fixierbar ist. Das erste Teil wird beispielsweise an der Anwendung verschraubt. Das zweite Teil (welches beispielsweise die Haltemodul-Anschlusseinrichtung trägt) wird dann an dem ersten Teil fixiert. Beispielsweise ist eine Schwalbenschwanzführung vorgesehen.

Es kann vorgesehen sein, dass die mindestens eine aktive Sensorfläche parallel zu einer Montageseite des Haltemoduls oder quer (insbesondere senkrecht) zu einer Montageseite des Haltemoduls ist. Je nach Anwendung lässt sich dadurch das Sichtfeld der Sensorvorrichtung einstellen. Die Montageseite des Haltemoduls ist diejenige Seite, welche der Anwendung zugewandt ist. Beispielsweise liegt die Montageseite bei an der Anwendung fixiertem Haltemodul an der Anwendung an.

Es ist möglich, dass eine Aufsteckrichtung des Sensormoduls auf das Haltemodul quer (insbesondere senkrecht) oder parallel zu einer Montageseite des Haltemoduls an einer Anwendung ist. Je nach Anwendung lässt sich dadurch eine optimale Montierbarkeit mit optimiertem Sichtfeld der Sensorvorrichtung gewährleisten.

Es kann vorgesehen sein, dass das Haltemodul und das Sensormodul so ausgebildet sind, dass das Sensormodul, wenn es an dem Haltemodul gehalten ist, über eine Oberfläche des Haltemoduls hinausragt, mit einer Oberfläche des Haltemoduls bündig ist oder gegen diese zurückgesetzt ist. Je nach Anwendungsfall lässt sich dadurch die optimale Positionierung des Sensormoduls mit seiner mindestens einen aktiven Fläche erreichen. Beispielsweise kann es vorteilhaft sein, um Beschädigungen des Sensormoduls zu verhindern, wenn dieses bündig mit einer Oberfläche ist oder zurückgesetzt ist. Bei anderen Anwendungen lässt sich das Gesichtsfeld optimieren, wenn das Sensormodul über die Oberfläche hinausragt.

Günstig ist es, wenn das Haltemodul einen Signalanschluss und einen elektrischen Anschluss aufweist. Es kann weiterhin vorgesehen sein, dass das Haltemodul einen Überwachungssignalanschluss aufweist. Diese Anschlüsse können zusammengefasst sein, so dass sie über ein einziges Kabel zu dem Haltemodul geführt werden kann, wobei dann einzelne Drähte zu der Haltemodul-Anschlusseinrichtung geführt sind, um für die elektrische Verbindung zu sorgen.

Beispielsweise ist von dem Haltemodul ein Kabel weggeführt. Dadurch lässt sich auf einfache Weise eine sichere Anschlussverbindung zwischen dem Haltemodul und dem Kabel erreichen.

Es ist auch möglich, dass das Haltemodul eine Platine ist. Das Sensorelement lässt sich dann auf einfache Weise an der Platine anordnen.

Ganz besonders vorteilhaft ist es, wenn das Gehäuse des Sensormoduls eine Höhe aufweist, welche höchstens zweifach so groß ist wie der größte Durchmesser senkrecht zu der Höhe. Beispielsweise ist die Höhe kleiner als der größte Durchmesser senkrecht zu der Höhe. Dadurch lässt sich ein Sensormodul bereitstellen, welches knopfförmig ausgebildet ist. Ein solches Sensormodul mit entsprechenden geringen Abmessungen lässt sich für eine Vielzahl von Anwendungen einsetzen.

Beispielsweise ist das Gehäuse des Sensormoduls zylindrisch oder quaderförmig ausgebildet. Dadurch lässt sich eine kompakte äußere Gestalt erreichen.

Es ist ferner günstig, wenn die mindestens eine aktive Sensorfläche durch eine Gehäuseseite des Sensormoduls bestimmt ist. Dadurch ergibt sich eine leichte Positionierbarkeit bzw. Ausrichtbarkeit des Sensormoduls bezogen auf eine Anwendung.

Beispielsweise ist die mindestens eine aktive Sensorfläche durch eine der Sensormodul-Anschlusseinrichtung gegenüberliegende Gehäuseseite bestimmt oder die mindestens eine aktive Sensorfläche liegt quer zu einer Gehäuseseite, an welche die Sensormodul-Anschlusseinrichtung angeordnet ist. Durch die Bereitstellung eines Sensormoduls und eines Haltemoduls lässt sich jegliche Ausrichtung der aktiven Sensorfläche auf einfache Weise realisieren.

Insbesondere ist das mindestens eine Sensorelement ein induktives Sensorelement (eine Spule) oder kapazitives Sensorelement. Dadurch lässt sich ein induktiver Näherungssensor oder kapazitiver Näherungssensor realisieren. Die Spule ist beispielsweise auf einen Träger aufgesteckt oder aufgelötet oder als Printspule und insbesondere Flachspule auf dem Träger angeordnet.

Günstigerweise ist das mindestens eine Sensorelement eine Spule, welcher ein Spulenkern wie beispielsweise ein Ferritkern zugeordnet ist. Dadurch lässt sich die Sensorwirkung des Sensorelements optimieren.

Günstigerweise ist die Sensorvorrichtung ausgebildet als Abstandssensorvorrichtung oder Positionssensorvorrichtung oder Näherungssensorvorrichtung oder Tastervorrichtung. Es können dabei analoge Signale und/oder digitale Signale (Schaltsignale) bezüglich der Annäherung bzw. Schaltsignale bezüglich der Anwesenheit/Abwesenheit eines Gegenstands bereitgestellt werden.

Günstig ist es, wenn das Sensormodul einen Träger aufweist, welcher im wesentlichen parallel zu mindestens einem Sensorelement orientiert ist. Wenn das Sensorelement eine Spule ist, dann ist der Träger vorzugsweise parallel zu einer Spulenfläche orientiert, das heißt eine Spulenachse ist quer und insbesondere senkrecht zum Träger orientiert. Dadurch lässt sich ein kompaktes Sensormodul realisieren.

Günstigerweise ist das mindestens eine Sensorelement auf den Träger aufgesteckt oder aufgelötet oder aufgedruckt. Dadurch lässt sich das entsprechende Sensormodul auf einfache Weise herstellen und insbesondere automatisch maschinell herstellen.

Günstig ist es, wenn zwischen dem mindestens einen Sensorelement und dem Träger ein Zwischenraum gebildet ist. In den Zwischenraum lassen sich Bauteile des Sensormoduls unterbringen. Dadurch lässt sich ein kompakter Aufbau realisieren.

Insbesondere sind in dem Zwischenraum ein oder mehrere elektronische Bauteile angeordnet, um einen kompakten Aufbau zu erreichen.

Günstig ist es, wenn der Träger parallel zu einer Gehäuseseite des Gehäuses des Sensormoduls angeordnet ist. Bei der Gehäuseseite handelt es sich insbesondere um eine Gehäusestirnseite. Dadurch lässt sich ein kompakter Aufbau realisieren.

Besonders vorteilhaft ist es, wenn der Träger parallel zu einer aktiven Sensorfläche angeordnet ist. Dadurch ergibt sich ein kompakter Aufbau. Beispielsweise lässt sich ein Sensormodul knopfförmig ausbilden.

Günstig ist es, wenn an einem Träger und/oder an dem Gehäuse Kontaktstifte angeordnet sind. Dadurch lässt sich eine Sensormodul-Anschlusseinrichtung auf einfache Weise realisieren und ein Sensormodul lässt sich auf einfache Weise an einem Haltemodul fixieren.

Die eingangs genannte Aufgabe wird bei der eingangs genannten induktiven Sensorvorrichtung ferner erfindungsgemäß dadurch gelöst, dass ein Signalanschluss und ein Energieversorgungsanschluss an einer Gehäuseseitenseite zwischen der ersten Gehäusestirnseite und der zweiten Gehäusestirnseite angeordnet ist.

Bei der erfindungsgemäßen Lösung lässt sich ein Kabel seitlich von der Sensoreinheit wegführen. Dies kann für Anwendungen vorteilhaft sein, bei denen kein Raum hinter der zweiten Gehäusestirnseite zur Verfügung steht.

Weitere vorteilhafte Ausführungsformen dieser erfindungsgemäßen Sensorvorrichtung wurden bereits oben erläutert.

Die eingangs genannte Aufgabe wird ferner erfindungsgemäß dadurch gelöst, dass das Gehäuse eine Höhe aufweist, welche höchstens zweifach so groß ist wie der größte Durchmesser senkrecht zu der Höhe.

Dadurch lässt sich eine Sensoreinheit ausbilden, welche kompakt aufgebaut ist. Es lässt sich eine Sensoreinheit realisieren, welche knopfförmig ist.

Beispielsweise ist die Höhe des Gehäuses höchstens zweifach so groß wie der größte Durchmesser senkrecht zu der Höhe.

Es kann vorgesehen sein, dass an dem Träger ein Steckerelement angeordnet ist, welches insbesondere starr mit dem Träger verbunden ist. Das Steckerelement kann dabei grundsätzlich als Haltemodul ausgebildet sein. Es lässt sich dadurch mindestens ein Sensorelement auf dem Träger positionieren, wobei gleichzeitig das Steckerelement an demselben Träger sitzt.

Insbesondere weist das Steckerelement Kontaktstifte auf. Beispielsweise sind vier Kontaktstifte vorgesehen. Dadurch lässt sich auf einfache Weise ein elektrischer Kontakt herstellen.

Bei einer Ausführungsform sitzt das mindestens eine induktive Element auf einer Seite des Trägers und elektronische Bauelemente sind auf der gegenüberliegenden Seite des Trägers angeordnet. Beispielsweise sind elektronische Bauelemente in einem Chip realisiert. Das mindestens eine induktive Element ist insbesondere als Printspule ausgebildet. Dadurch lässt sich eine induktive Sensorvorrichtung mit kleinen Höhenabmessungen bereitstellen.

Weitere vorteilhafte Ausführungsformen wurden ebenfalls bereits oben geschildert.

Die nachfolgende Beschreibung bevorzugter Ausführungsformen dient im Zusammenhang mit der Zeichnung der näheren Erläuterung der Erfindung. Es zeigen:
- Figur 1: eine schematische seitliche Schnittdarstellung eines ersten Ausführungsbeispiels einer erfindungsgemäßen Sensorvorrichtung/eines erfindungsgemäßen Sensormoduls;
- Figur 2: eine Explosionsdarstellung der Sensorvorrichtung/des Sensormoduls gemäß Figur 1;
- Figur 3: ein zweites Ausführungsbeispiel eines Sensormoduls;
- Figur 4: ein drittes Ausführungsbeispiel eines Sensormoduls;
- Figur 5: ein viertes Ausführungsbeispiel eines Sensormoduls;
- Figur 6: ein erstes Ausführungsbeispiel eines Haltemoduls;
- Figur 7: ein zweites Ausführungsbeispiel eines Haltemoduls;
- Figur 8: ein drittes Ausführungsbeispiel eines Haltemoduls;
- Figur 9: ein viertes Ausführungsbeispiel eines Haltemoduls;
- Figur 10: ein fünftes Ausführungsbeispiel eines Haltemoduls;
- Figur 11: ein sechstes Ausführungsbeispiel eines Haltemoduls;
- Figur 12: ein siebtes Ausführungsbeispiel eines Haltemoduls;
- Figur 13: ein achtes Ausführungsbeispiel eines Haltemoduls mit fixiertem Sensormodul;
- Figur 14: ein neuntes Ausführungsbeispiel eines Haltemoduls;
- Figur 15: ein zehntes Ausführungsbeispiel eines Haltemoduls;
- Figur 16: ein elftes Ausführungsbeispiel eines Haltemoduls;
- Figur 17: ein zwölftes Ausführungsbeispiel eines Haltemoduls;
- Figur 18: eine schematische Darstellung einer an einem Profilträger fixierten erfindungsgemäßen Sensorvorrichtung;
- Figur 19(a) und (b): ein dreizehntes Ausführungsbeispiel einer erfindungsgemäßen Sensorvorrichtung;
- Figur 20: ein vierzehntes Ausführungsbeispiel einer erfindungsgemäßen Sensorvorrichtung;
- Figur 21: ein fünfzehntes Ausführungsbeispiel einer erfindungsgemäßen Sensorvorrichtung; und
- Figur 22: ein sechzehntes Ausführungsbeispiel einer erfindungsgemäßen Sensorvorrichtung.

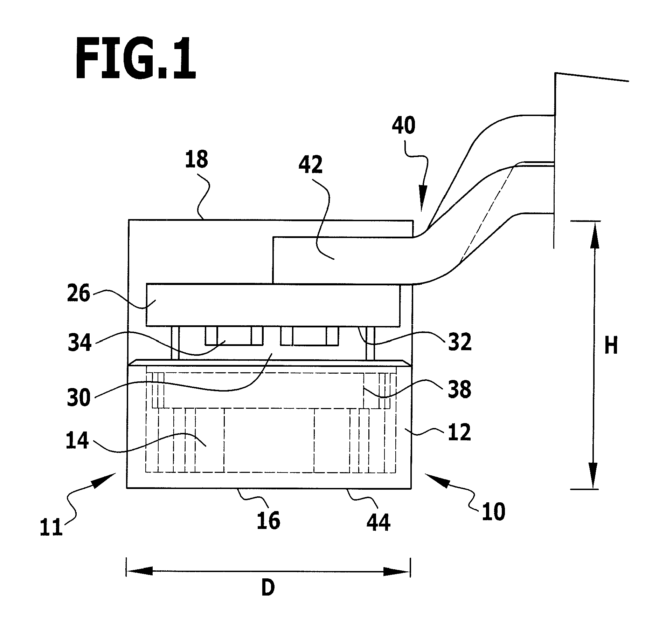

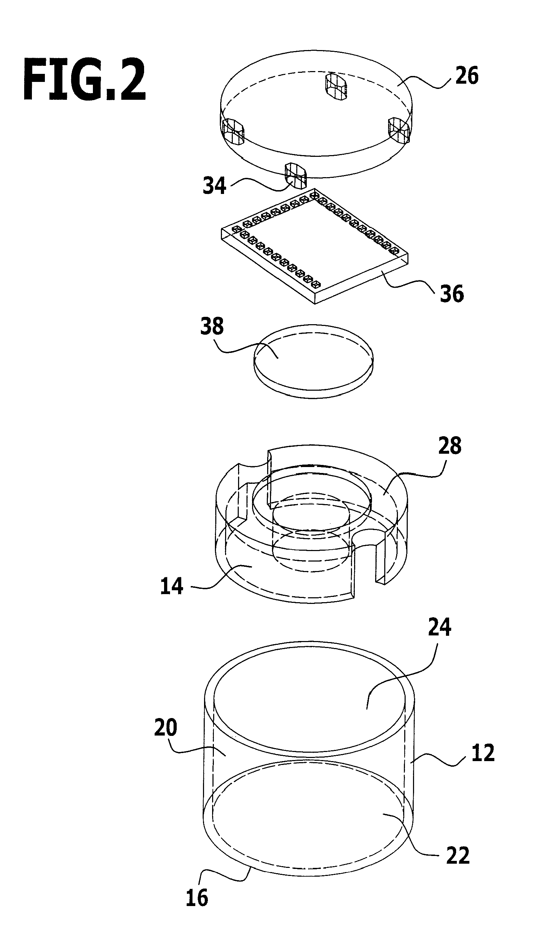

Ein erstes Ausführungsbeispiel einer erfindungsgemäßen Sensorvorrichtung, welches in den Figuren 1 und 2 gezeigt und dort mit 10 bezeichnet ist, umfasst eine Sensoreinheit 11 mit einem Gehäuse 12, in welchem (mindestens ein) Sensorelement 14 angeordnet ist. Das Sensorelement 14 ist insbesondere eine Spule. Die Sensorvorrichtung 10 ist dann insbesondere eine induktive Sensorvorrichtung. Sie ist beispielsweise als Abstandssensor bzw. Näherungssensor bzw. Positionssensor ausgebildet. Es kann dabei eine analoge Abstandsbestimmung bzw. Annäherungsbestimmung bzw. Positionsbestimmung erfolgen oder es können ein oder mehrere Schaltpunkte generiert werden. Im letzteren Falle ist die Sensorvorrichtung 10 ein Abstandsschalter bzw. Näherungsschalter bzw. Positionsschalter. Die Sensorvorrichtung 10 kann beispielsweise auch als Taster zur Bestimmung der Anwesenheit/Abwesenheit eines Gegenstands ausgebildet sein. Sie kann beispielsweise als 2-Draht-Schalter oder 3-Draht-Schalter ausgebildet sein.

Das Gehäuse 12 weist eine erste Gehäusestirnseite 16 auf. Der ersten Gehäusestirnseite 16 gegenüberliegend ist eine zweite Gehäusestirnseite 18 vorgesehen.

Bei dem in den Figuren 1 und 2 gezeigten Ausführungsbeispiel sitzt an der ersten Gehäusestirnseite 16 einstückig eine Seitenwand 20, durch welche eine Gehäuseseitenseite 22 gebildet ist, welche nach außen weist. Das Gehäuse 12 weist einen Aufnahmeraum 24 für das Sensorelement 14 auf.

Das Sensorelement 14 ist an einem Träger 26 angeordnet, welcher innerhalb des Gehäuses 12 zwischen der ersten Gehäusestirnseite 16 und der zweiten Gehäusestirnseite 18 positioniert ist.

Wenn das Sensorelement 14 ein induktives Element, das heißt eine Spule ist, dann ist bei einer Ausführungsform diesem ein Spulenkern 28 wie beispielsweise ein Ferritkern zugeordnet. Das Sensorelement 14 mit dem Spulenkern 28 ist beabstandet zu dem Träger 26 angeordnet, so dass ein Zwischenraum 30 zwischen dem Träger 26 und dem Sensorelement 14 mit dem Spulenkern 28 gebildet ist. Die beabstandete Anordnung des Sensorelements 14 zu dem Träger 26 und insbesondere zu einer Trägerfläche 32 lässt sich beispielsweise dadurch erreichen, dass Abstandselemente 34 an dem Träger 26 sitzen, wobei das Sensorelement 14 mit dem Spulenkern 28 wiederum an den Abstandselementen 34 sitzt. Die Abstandselemente 34 können gleichzeitig als elektrische Verbindungselemente zur elektrischen Verbindung von elektronischen Bauteilen auf dem Träger 26 und dem Sensorelement 14 dienen.

In dem Zwischenraum 30 können ein oder mehrere elektronische Bauteile 36 der Sensorvorrichtung 10 positioniert sein.

Es kann vorgesehen sein, dass zwischen dem oder den elektronischen Bauelementen 36 und dem Sensorelement 14 mit dem Spulenkern 28 ein Zwischenelement 38 sitzt. Dieses ist beispielsweise scheibenförmig ausgebildet und sitzt in einer entsprechenden Ausnehmung des Spulenkerns 28. Das Zwischenelement 38 dient beispielsweise als Abschirmelement zwischen dem Sensorelement 14 und dem oder den elektronischen Bauelementen 36.

Eine Höhe H des Gehäuses 12 ist höchstens zweifach so groß wie der Durchmesser D des Gehäuses 12 senkrecht zu dieser Höhe H. Die Sensorvorrichtung 10 ist dadurch knopfartig ausgebildet. Sie weist geringe Außenmaße auf.

Bei dem in den Figuren 1 und 2 gezeigten Ausführungsbeispiel hat das Gehäuse 12 eine zylindrische Form. Es sind aber auch andere Gehäuseformen möglich.

Die Sensorvorrichtung 10 weist eine Anschlusseinrichtung 40 auf, welche seitlich an dem Gehäuse 12 angeordnet ist. Die Anschlusseinrichtung 40 ist insbesondere zwischen der Gehäusestirnseite 18 und dem Träger 26 an der Seitenwand 20 angeordnet. Insbesondere ist die Anschlusseinrichtung 40 eine elektrische Anschlusseinrichtung. Beispielsweise sind an das Gehäuse 12 elektrische Kabel 42 zur Energieversorgung der Sensorvorrichtung 10 sowie zur Signalauskopplung geführt. Diese Kabel 42 sind insbesondere an entsprechende Kontaktelemente, welche beispielsweise am Träger 26 angeordnet sind, angelötet.

Die Sensorvorrichtung 10 weist eine aktive Sensorfläche 44 auf, welche bei dem Ausführungsbeispiel gemäß den Figuren 1 und 2 durch die erste Gehäusestirnseite 16 bestimmt ist. Der Sensorvorrichtung 10 ist ein vorderes Sichtfeld zugeordnet, in welchem eine aktive Detektion stattfinden kann, wobei das Sichtfeld durch die aktive Sensorfläche 44 definiert wird.

Der Träger 26 und das Sensorelement 14 sind parallel zueinander orientiert. Wenn das Sensorelement 14 eine Spule ist, dann ist die Spulenachse senkrecht zu dem Träger 26 ausgerichtet. Der Träger 26 ist parallel zu der aktiven Sensorfläche 44. Dadurch lässt sich ein platzsparender kompakter Aufbau für die Sensorvorrichtung 10 erreichen.

Die Sensoreinheit 11 lässt sich insbesondere als Sensormodul zur Fixierung an einem Haltemodul, wie unten noch näher beschrieben wird, ausbilden, wenn die Anschlusseinrichtung 40 entsprechend ausgebildet ist und insbesondere Kontaktstifte aufweist. Sie kann auch als "eigenständige" Sensoreinheit ausgebildet sein.

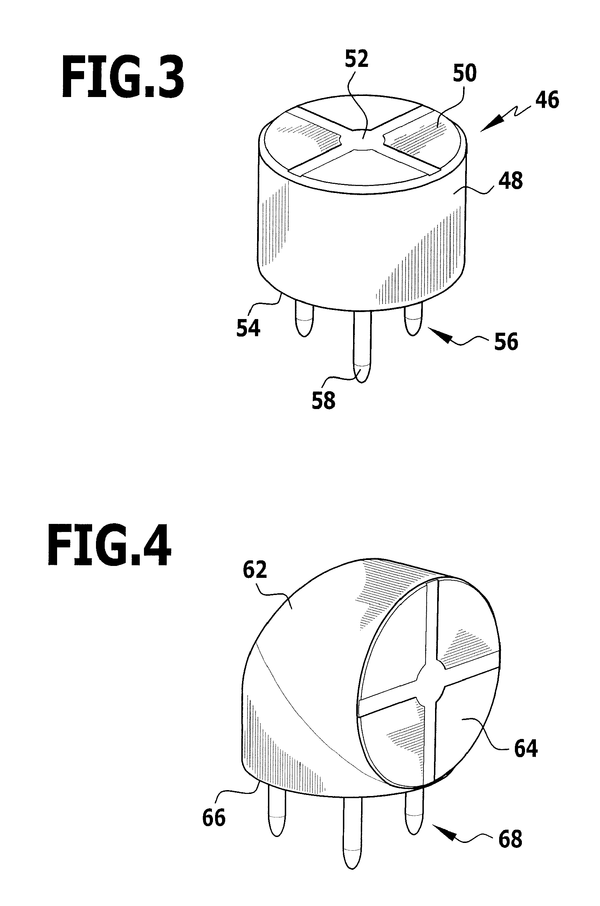

Bei einem weiteren Ausführungsbeispiel einer erfindungsgemäßen Sensorvorrichtung ist, wie in Figur 3 gezeigt, ein Sensormodul 46 vorgesehen, welches ein Gehäuse 48 aufweist, in dem ein Sensorelement und insbesondere eine Spule angeordnet ist. Die Anordnung in dem Gehäuse ist grundsätzlich gleich wie oben anhand der Sensoreinheit 11 beschrieben.

Das Gehäuse 48 weist eine erste Gehäusestirnseite 50 auf, welche eine aktive Sensorfläche 52 bestimmt. An einer der ersten Gehäusestirnseite 50 gegenüberliegenden zweiten Gehäusestirnseite 54 ist eine Sensormodul-Anschlusseinrichtung 56 angeordnet. Die Sensormodul-Anschlusseinrichtung 56 umfasst eine Mehrzahl von Stiften 58, welche als Kontaktstifte ausgebildet sind. Die Kontaktstifte 58 sind starr. Über sie ist das Sensormodul 46 in entsprechende Stiftaufnahmen eines Haltemoduls aufsteckbar, um für eine mechanische und elektrische Verbindung zwischen dem Sensormodul 46 und einem Haltemodul zu sorgen.

Die Kontaktstifte 58 sind an ihrem unteren Ende verjüngt, um die Einführung in entsprechende Stiftaufnahmen zu erleichtern.

Es sind beispielsweise drei Kontaktstifte 58 vorgesehen; ein Kontaktstift dient zur Signalauskopplung und die beiden anderen Kontaktstifte dienen zur elektrischen Energieversorgung. Es ist beispielsweise auch möglich, dass noch weitere Kontaktstifte vorgesehen sind. Beispielsweise kann ein weiterer Kontaktstift für die Auskopplung eines Sensormodul-Überwachungssignals dienen.

Bei dem Sensormodul 46 liegen die aktive Sensorfläche 52 und die Sensormodul-Anschlusseinrichtung 56 einander gegenüber.

Das Gehäuse 48 ist zylindrisch ausgebildet.

Es kann auch vorgesehen sein, wie beispielhaft anhand eines dritten Ausführungsbeispiels eines Sensormoduls 60 (Figur 4) gezeigt, dass ein entsprechendes Gehäuse 62 so ausgebildet ist, dass eine aktive Fläche 64 und eine Gehäusestirnseite 66, an welcher eine Sensormodul-Anschlusseinrichtung 68 mit Kontaktstiften angeordnet sind, quer und insbesondere senkrecht zueinander liegen.

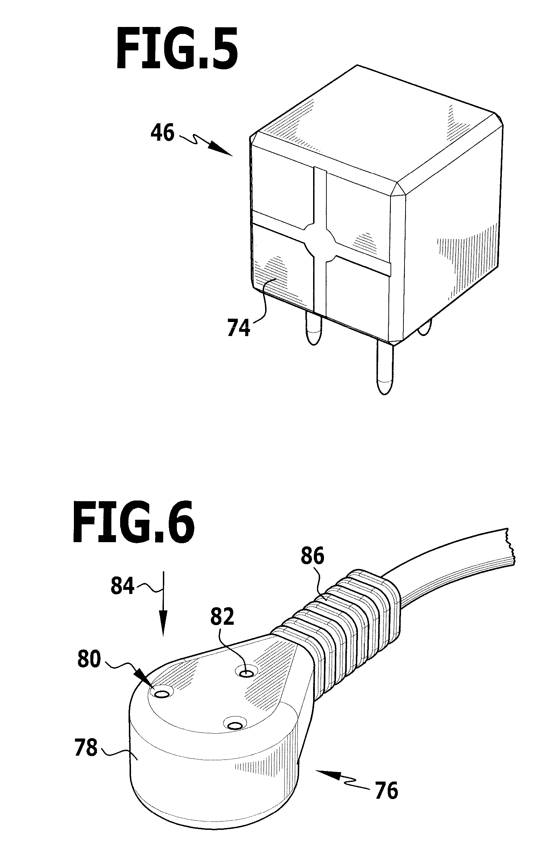

Bei einem vierten Ausführungsbeispiel eines Sensormoduls, welches in Figur 5 gezeigt und dort mit 70 bezeichnet ist, ist ein Gehäuse 72 vorgesehen, welches quaderförmig ausgebildet ist. Bei dem gezeigten Ausführungsbeispiel ist ähnlich wie bei dem Sensormodul 60 eine aktive Sensorfläche 74 quer zu einer Gehäuseseite angeordnet, an welcher wiederum eine Sensormodul-Anschlusseinrichtung sitzt. Es ist auch eine gegenüberliegende Anordnung möglich.

Zur Fixierung eines Sensormoduls an einer Anwendung ist ein Haltemodul vorgesehen. Über das Haltemodul wird das entsprechende Sensormodul mit elektrischer Energie versorgt. Ferner erfolgt die Signalauskopplung an der entsprechenden Sensorvorrichtung über das Haltemodul. Es kann auch die Auskopplung von Sensormodul-Überwachungssignalen durch das Haltemodul vorgesehen sein. Ein entsprechendes Haltemodul weist dafür einen elektrischen Energieversorgungsanschluss und einen Signalauskopplungsanschluss auf. Wenn eine Sensorüberwachung vorgesehen ist, dann weist das Haltemodul auch einen entsprechenden Überwachungssignalausgangsanschluss auf.

Durch die Trennung zwischen Sensormodul und Haltemodul ist eine Anpassung an spezielle Anwendungen auf einfache Weise möglich. Die Anpassung an die Anwendung erfolgt über das Haltemodul. Es werden entsprechende Haltemodule bereitgestellt, über die sich insbesondere die mechanische Fixierbarkeit an der Anwendung optimieren lässt. Bei der Ausbildung an Haltemodulen kann eine große Variabilität vorliegen. Als Sensormodul werden nur eine geringe Anzahl an Varianten bereitgestellt; im Extremfall wird nur eine einzige Art eines Sensormoduls bereitgestellt. Dennoch lässt sich aufgrund der Trennung in Sensormodul und Haltemodul eine breite Einsatzvariabilität erreichen. Die Sensormodule lassen sich auf einfache und kostengünstige Weise herstellen und auch in Vorrat halten, da die Variabilität hier eingeschränkt ist.

Ein erstes Ausführungsbeispiel eines Haltemoduls, welches in Figur 6 gezeigt und dort mit 76 bezeichnet ist, umfasst einen Träger 78, an dem eine Haltemodul-Anschlusseinrichtung 80 angeordnet ist. Diese umfasst Stiftaufnahmen 82, welche an entsprechende Kontaktstifte des Sensormoduls, beispielsweise die Kontaktstifte 58 des Sensormoduls 46, angepasst sind. Beispielsweise sind drei oder vier Stiftaufnahmen 82 vorgesehen.

Beispielsweise weist ein Haltemodul vier Stiftaufnahmen auf, welche so ausgebildet sind, dass auch ein Sensormodul mit nur drei Kontaktstiften fixierbar ist. Wenn ein Sensormodul keinen Kontaktstift für einen Überwachungsausgang hat, dann erfolgt hier auch kein Anschluss.

Das entsprechende Sensormodul (beispielsweise das Sensormodul 46) ist in einer Aufsteckrichtung 84 auf das Haltemodul aufsteckbar. Ein auf das Haltemodul 76 aufgestecktes Sensormodul 46 ist an dem Haltemodul 76 gehalten, das heißt mechanisch fixiert. Ferner erfolgt eine elektrische Kontaktierung.

Das Haltemodul 76 weist einen Anschluss 86 für die Signalauskopplung und die elektrische Energieversorgung auf. Beispielsweise ist an dem Haltemodul 76 ein entsprechendes Kabel mit Anschlussdrähten angeordnet, wobei die Anschlussdrähte zu den Stiftaufnahmen 82 geführt sind.

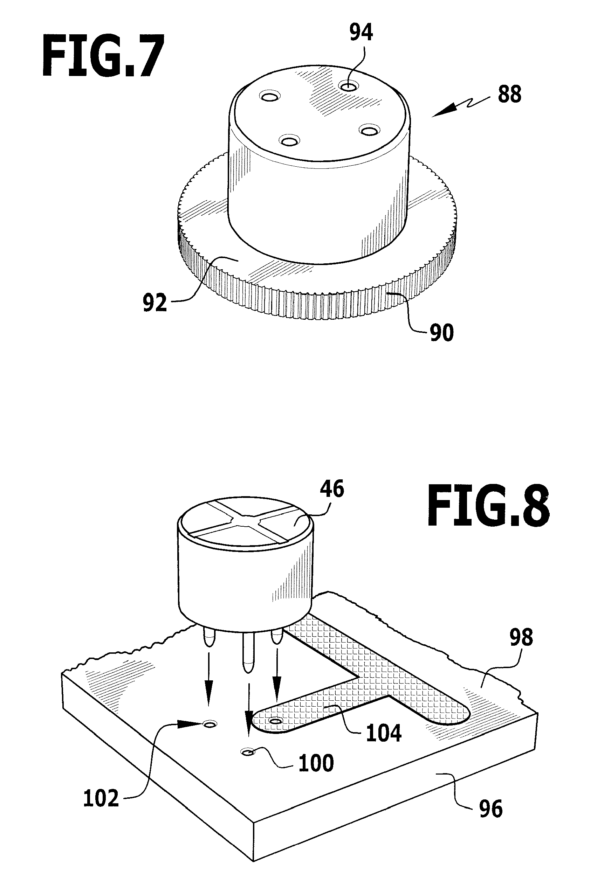

Ein Haltemodul weist eine Montageeinrichtung auf. Bei einem Haltemodul, welches in Figur 7 gezeigt und dort mit 88 bezeichnet ist, ist eine Montageeinrichtung 90 vorgesehen, welche als Mutter 92 ausgebildet ist. Über die Mutter 92 ist das Haltemodul 88 auf eine Anwendung aufschraubbar.

Bei dem gezeigten Ausführungsbeispiel weist das Haltemodul 88 vier Stiftaufnahmen 94 für entsprechende vier Kontaktstifte eines Sensormoduls auf.

Es ist auch möglich, dass ein Haltemodul 96, wie in Figur 8 gezeigt, selbst Teil einer Anwendung ist. Beispielsweise ist das Haltemodul an einer oder durch eine Platine 98 gebildet. Die Platine 98 ist mit Stiftaufnahmen 100 versehen, wobei ein Sensormodul 46 auf die Platine 98 über die Stiftaufnahmen 100 aufsteckbar ist. Durch die Stiftaufnahmen 100 ist eine entsprechende Haltemodul-Anschlusseinrichtung 102 der Platine 98 gebildet.

Zu den Stiftaufnahmen 100 sind entsprechende Leiterbahnen 104 an der Platine geführt, um über die Platine 98 die elektrische Energieversorgung des Sensormoduls 46 zu ermöglichen sowie von dem Sensormodul 46 gelieferte Sensorsignale zur Weiterverarbeitung abführen zu können.

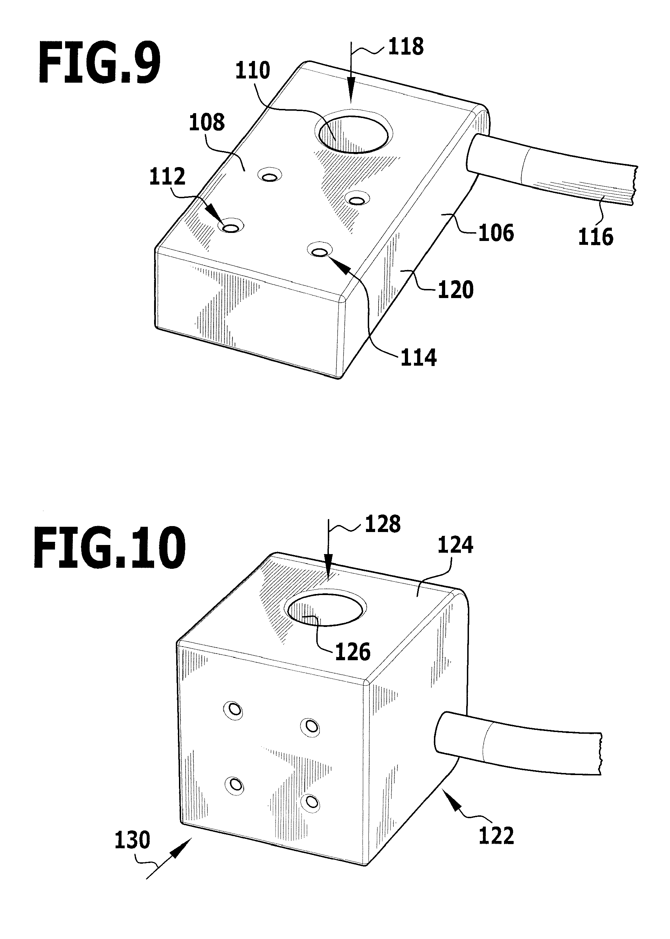

Ein viertes Ausführungsbeispiel eines Haltemoduls, welches in Figur 9 gezeigt und mit 106 bezeichnet ist, umfasst einen Träger 108, welcher (mindestens) eine durchgehende Ausnehmung 110 aufweist. Diese durchgehende Ausnehmung 110 ist beispielsweise in Form einer Bohrung ausgebildet. Über die Ausnehmung 110 lässt sich der Träger 108 und dadurch das Haltemodul 106 an einer Anwendung beispielsweise durch Verschraubung fixieren.

Zur Ausbildung einer Haltemodul-Anschlusseinrichtung 112 sind an dem Träger 108 Stiftaufnahmen 114 für Kontaktstifte eines Sensormoduls gebildet. Drähte eines Kabels 116 sind zu diesen Stiftaufnahmen geführt. Das Kabel 116 ist beispielsweise in der Nähe eines Trägers an diesen anschlossen.

Bei dem in Figur 9 gezeigten Ausführungsbeispiel sind die Stiftaufnahmen 114 parallel zu der Ausnehmung 110 angeordnet, das heißt die Ausnehmung 110 weist eine Orientierungsrichtung 118 auf, welche parallel zu der Aufsteckrichtung eines Sensormoduls auf das Haltemodul 106 ist.

Das Haltemodul 106 weist eine über den Träger 108 definierte Montageseite 120 auf, welche bei der Montage der Anwendung zugewandt ist und insbesondere an der Anwendung anliegt. Die Montageseite 120 ist quer und insbesondere senkrecht zu der Aufsteckrichtung orientiert.

Wenn das Sensormodul 46 auf das Haltemodul 106 aufgesteckt wird, dann liegt die aktive Sensorfläche 52 im wesentlichen parallel zur Montageseite 120.

Es ist auch möglich, wie bei einem fünften Ausführungsbeispiel eines Haltemoduls 122 gezeigt (Figur 10), dass ein Träger 124 vorgesehen ist, in welchem (mindestens) eine durchgehende Ausnehmung 126 angeordnet ist, die in einer Richtung 128 orientiert ist, welche quer und insbesondere senkrecht zu einer Aufsteckrichtung 130 eines Sensormoduls ist.

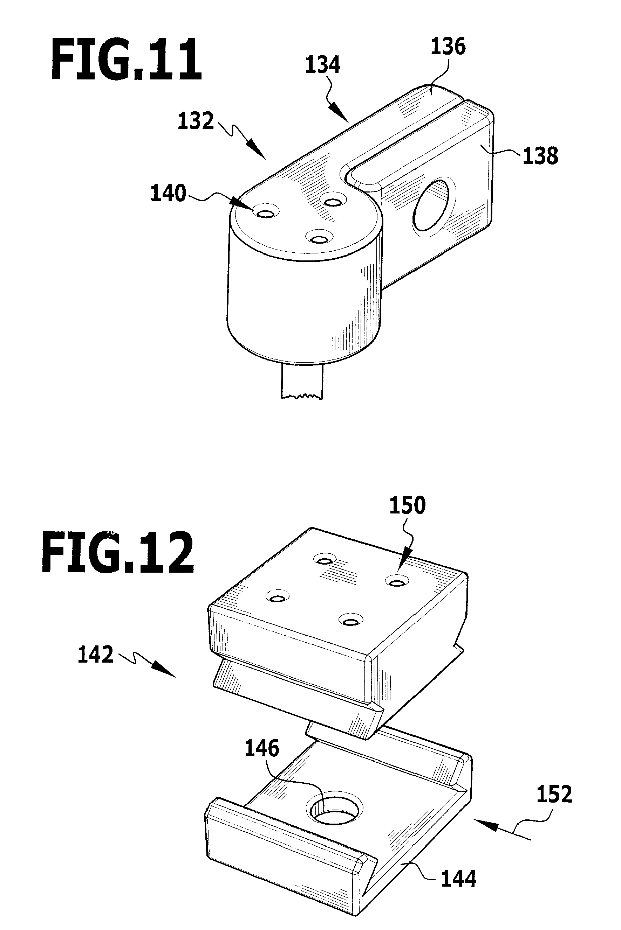

Es ist beispielsweise auch möglich, dass ein Haltemodul mehrteilig ausgebildet ist. Bei einem sechsten Ausführungsbeispiel eines Haltemoduls, welches in Figur 11 gezeigt und dort mit 132 bezeichnet ist, ist ein zweiteiliger Träger 134 vorgesehen. Der Träger 134 umfasst ein erstes Teil 136 und ein zweites Teil 138. Diese sind beweglich zueinander, so dass der Träger 134 über das erste Teil 136 und das zweite Teil 138 an einer Anwendung verspannbar ist. Ein Anwendungselement lässt sich zwischen dem ersten Teil 136 und dem zweiten Teil 138 verklemmen, um dadurch das Haltemodul 132 an der Anwendung zu fixieren.

Das Haltemodul 132 weist wiederum eine Haltemodul-Anschlusseinrichtung 140 auf, um ein Sensormodul aufzunehmen und dieses an dem Haltemodul mechanisch zu fixieren und für die elektrische Verbindung zu sorgen, das heißt für die elektrische Energieversorgung des Sensormoduls zu sorgen und für die Auskopplung von Sensorsignalen über das Haltemodul 132 zu sorgen.

Bei einem siebten Ausführungsbeispiel eines Haltemoduls, welches in Figur 12 gezeigt und dort mit 142 bezeichnet ist, ist ein erstes Teil 144 vorgesehen, welches an einer Anwendung fixierbar ist und beispielsweise an dieser verschraubbar ist. Dazu weist das erste Teil 144 eine oder mehrere durchgehende Ausnehmungen 146 auf. Es ist ein zweites Teil 148 vorgesehen, welches eine Haltemodul-Anschlusseinrichtung mit entsprechenden Stiftaufnahmen trägt. Das zweite Teil 148 ist an dem ersten Teil 144 fixierbar. Beispielsweise ist das zweite Teil 148 auf das erste Teil 144 aufschiebbar.

Bei dem in Figur 12 gezeigten Ausführungsbeispiel ist das zweite Teil 148 auf das erste Teil 144 in einer Richtung 152 aufschiebbar, welche quer zu der Aufsteckrichtung eines Sensormoduls auf das Haltemodul 142 ist.

Beispielsweise ist eine Schwalbenschwanzführung vorgesehen, um das zweite Teil 148 an dem ersten Teil 144 zu führen und mindestens für eine Sperrung der Beweglichkeit parallel zur Aufsteckrichtung des Sensormoduls zu sorgen.

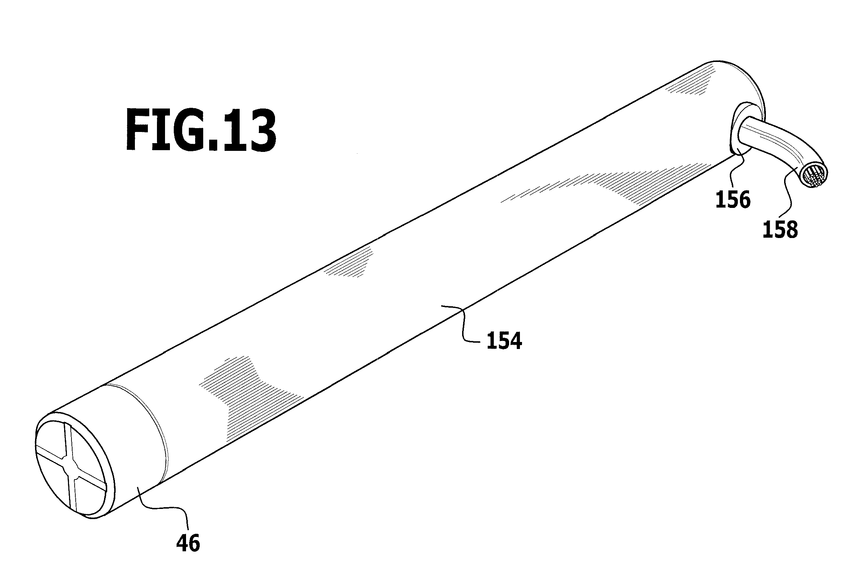

Es ist beispielsweise auch möglich, dass ein Haltemodul 154, wie in Figur 13 gezeigt, röhrenförmig ausgebildet ist. An oder in der Nähe eines Endes des Haltemoduls 154 ist ein Anschluss 156 vorgesehen, an dem beispielsweise ein Kabel 158 sitzt. Das Haltemodul 154 lässt sich an einer Klemme einspannen.

Beispielsweise ist das Haltemodul 154 stangenförmig ausgebildet. Es lässt sich dann als Stativstange einsetzen.

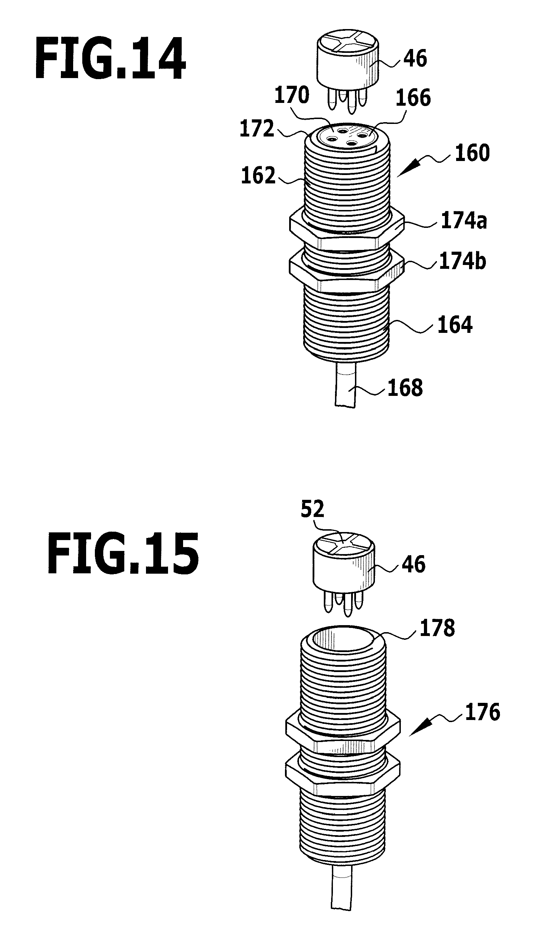

Bei einem neunten Ausführungsbeispiel eines Haltemoduls, welches in Figur 14 gezeigt und dort mit 160 bezeichnet ist, ist ein Träger 162 vorgesehen, welcher ein Außengewinde 164 aufweist. An oder in der Nähe eines Endes des Trägers 162 ist eine Haltemodul-Anschlusseinrichtung 166 gebildet. An einem gegenüberliegenden Ende führt ein Kabel 168 an den Träger 162, wobei entsprechende Drähte mit der Haltemodul-Anschlusseinrichtung 166 verbunden sind.

Die Haltemodul-Anschlusseinrichtung 166 weist ein Element 170 auf, in welchem Stiftaufnahmen angeordnet sind. Eine Oberfläche des Elements 170 ist bündig mit einer Stirnseite 172 des Trägers 162. Ein auf das Haltemodul 160 aufgesetztes Sensormodul 46 ragt dadurch über die Stirnseite 172 des Haltemoduls 160 hinaus.

Das Haltemodul 160 ist beispielsweise über Klemmmuttern 174a, 174b, welche an dem Außengewinde 164 geführt sind, an einer Anwendung fixierbar.

Bei einem weiteren Ausführungsbeispiel eines Haltemoduls, welches in Figur 15 gezeigt und dort mit 176 bezeichnet ist, ist wiederum ein Träger vorgesehen, welcher grundsätzlich gleich ausgebildet ist wie der Träger 162. Jedoch ist das Element entsprechende dem Element 170, in welchem Stiftaufnahmen gebildet sind, gegenüber einer Stirnseite 178 des Träges zurückgesetzt. Insbesondere ist die Zurücksetzung soweit, dass sich das Sensormodul 46 mit seiner aktiven Fläche 52 bündig mit der Stirnseite 178 des Trägers 178 an dem Haltemodul 176 fixieren lässt.

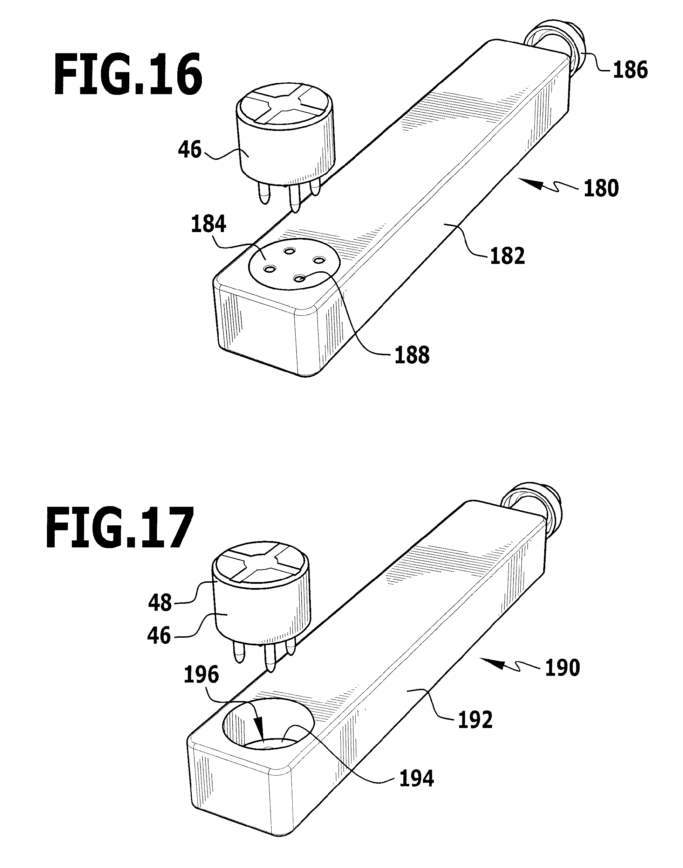

Bei einem weiteren Ausführungsbeispiel eines Haltemoduls, welches in Figur 16 gezeigt und dort mit 180 bezeichnet ist, ist an einem beispielsweise quaderförmig ausgebildeten Träger 182 eine Haltemodul-Anschlusseinrichtung 184 gebildet. An dieser ist ein Sensormodul 46 mechanisch fixierbar.

An einem Ende des Trägers 182 ist ein Anschluss 186 für die elektrische Energieversorgung und die Signalauskopplung angeordnet.

Ein oberes Ende von Stiftaufnahmen 188 der Haltemodul-Anschlusseinrichtung 184 ist bündig mit einer Oberfläche des Trägers 182 oder höchstens leicht zurückgesetzt.

Bei einem weiteren Ausführungsbeispiel eines Haltemoduls, welches in Figur 17 gezeigt und dort mit 190 bezeichnet ist, ist der Träger grundsätzlich gleich ausgebildet wie bei dem Haltemodul 180. Jedoch weist der entsprechende Träger 192 eine an die Form eines Sensormoduls angepasste Ausnehmung 194 auf, in welcher die Haltemodul-Anschlusseinrichtung 196 angeordnet ist. Insbesondere entspricht die Höhe der Ausnehmung 194 der Höhe des Gehäuses 48 beispielsweise des Sensormoduls 46. Dadurch lässt sich das Sensormodul 46 an dem Haltemodul 190 bündig mit einer Oberfläche des Trägers 192 oder versenkt anordnen.

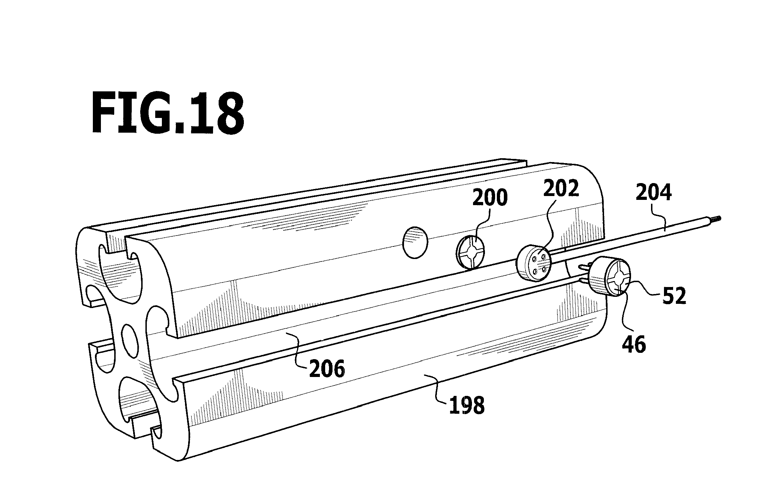

Eine erfindungsgemäße Sensorvorrichtung lässt sich beispielsweise an einem Profilträger 198 anordnen (Figur 18). Dazu wird der Profilträger mit einer entsprechenden Ausnehmung 200 versehen, in welcher ein Haltemodul 202 positioniert wird. Ein Kabel 204, welches an das Haltemodul 202 gekoppelt ist, wird beispielsweise in einer Nut 206 geführt.

Ein Sensormodul 46 wird an dem Haltemodul 202, welches in der Ausnehmung 200 sitzt, fixiert. Dadurch lässt es sich beispielsweise erreichen, dass eine aktive Sensorfläche 52 des Sensormoduls 46 bündig mit einer Oberfläche des Profilträgers 198 ist oder zurückgesetzt ist.

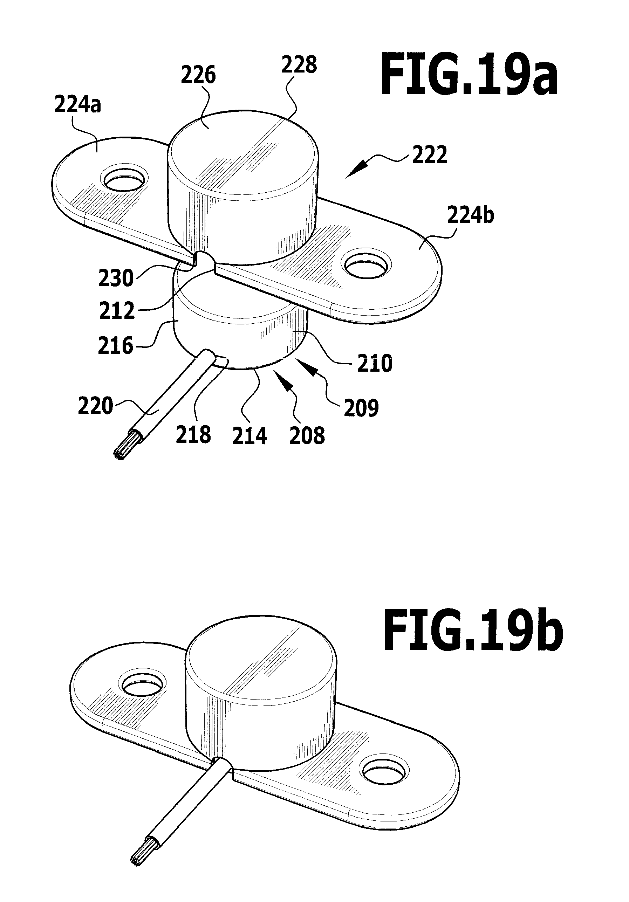

Bei einem weiteren Ausführungsbeispiel einer erfindungsgemäßen Sensorvorrichtung, welche in den Figuren 19(a) und 19(b) gezeigt und dort mit 208 bezeichnet ist, ist eine Sensoreinheit 209 mit einem Gehäuse 210 vorgesehen, welches grundsätzlich gleich ausgebildet ist wie das Gehäuse 12. Die Anordnung von Bauelementen innerhalb des Gehäuses 210 ist ebenfalls grundsätzlich so ausgebildet wie im Zusammenhang mit den Figuren 1 und 2 diskutiert. Das Gehäuse 210 weist eine erste Gehäusestirnseite 212 und eine gegenüberliegende zweite Gehäusestirnseite 214 auf. Das Gehäuse 210 ist über eine oder mehrere Gehäuseseitenseiten 216, welche zwischen der ersten Gehäusestirnseite 212 und der zweiten Gehäusestirnseite 214 liegen, geschlossen.

An der (oder einer) Gehäuseseitenseite 216 ist ein Anschluss 218 angeordnet. Beispielsweise ist ein Kabel 220 an den Anschluss 218 geführt und bezüglich des Gehäuses 210 fixiert.

Das Kabel 220 tritt dadurch nicht an der ersten Gehäusestirnseite 212 und der zweiten Gehäusestirnseite 214 aus, sondern seitlich. Dies kann für bestimmte Anwendungen vorteilhaft sein.

Beispielsweise umfasst die Sensorvorrichtung 208 einen Halter 222, über welchen eine Fixierung an einer Anwendung möglich ist. Der Halter 222 hat beispielsweise Flansche 224a, 224b, über welche der Halter 222 an einer Anwendung verschraubbar ist.

Bei dem gezeigten Ausführungsbeispiel umfasst der Halter 222 einen Aufnahmeraum 226, welcher in einem einseitig offenen Gehäuse 228 gebildet ist. Der Aufnahmeraum dient zur Aufnahme des Gehäuses 210, in welchem wiederum das Sensorelement angeordnet ist. Das Gehäuse 210 mit dem seitlichen Anschluss 218 (an dem ein Kabel 220 sitzen kann) lässt sich von der offenen Seite in das Gehäuse 228 einschieben.

Das Gehäuse 228 weist eine Ausnehmung 230 für die Kabeldurchführung auf.

Der Halter 222 mit dem in das Gehäuse 228 eingeschobenen Gehäuse 210 lässt sich auf eine Anwendung aufsetzen, wie in Figur 19(b) gezeigt. Die Herausbewegung des Gehäuses 210 nach unten ist dann gesperrt.

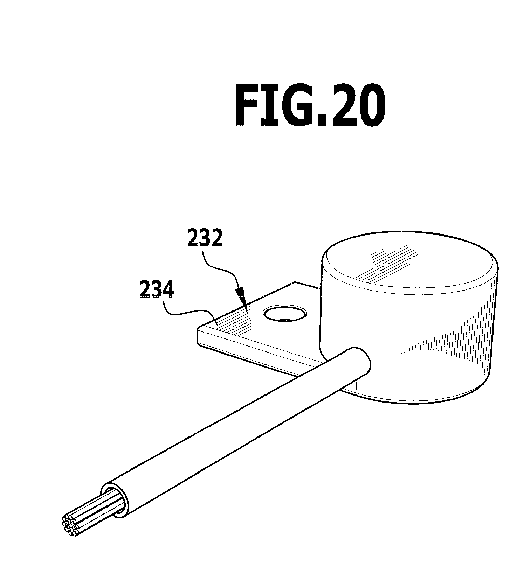

Es ist auch möglich, wie in Figur 20 gezeigt, dass ein Halter 232 einen einseitigen Flansch 234 aufweist, an welchem das Gehäuse 210 direkt sitzt.

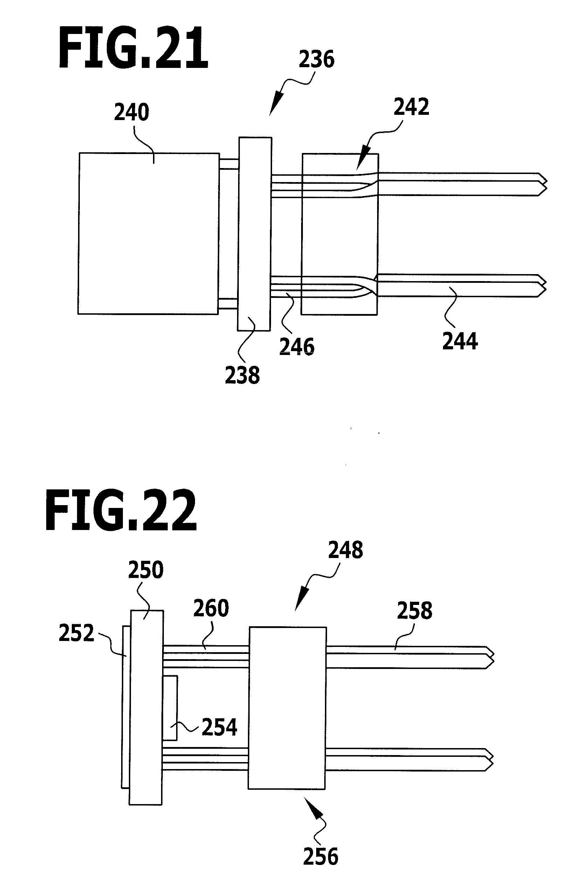

Bei einem fünfzehnten Ausführungsbeispiel einer erfindungsgemäßen Sensorvorrichtung, welches in Figur 21 (ohne Gehäuse) gezeigt und dort mit 236 bezeichnet ist, ist ein Träger 238 vorgesehen, an welchem eine Spule mit einem Spulenkern sitzt. Die Kombination von Spule und Spulenkern ist in Figur 21 mit dem Bezugszeichen 240 bezeichnet.

An dem Träger 238 sitzt ebenfalls ein Steckerelement 242, welches eine Mehrzahl von Kontaktstiften 244 aufweist. Die Kontaktstifte 244 weisen in eine Richtung von der Spulen-Spulenkern-Kombination 240 weg. Beispielsweise sind vier Kontaktstifte 244 vorgesehen. Die Kontaktstifte 244 sind über Kontaktelemente 246 mit dem Träger 238 verbunden, wobei die Kontaktelemente 246 für eine mechanische Verbindung und für eine elektrische Verbindung sorgen. Über die Kontaktelemente 246 ist das Steckerelement 242 starr an dem Träger 238 gehalten.

An demselben Träger 238 sitzen somit das (mindestens eine) Sensorelement, nämlich die Spule, und das Steckerelement 242.

Bei einem sechzehnten Ausführungsbeispiel, welches in Figur 22 (ohne Gehäuse) gezeigt und dort mit 248 bezeichnet ist, ist ein Träger 250 vorgesehen, an dessen einer Seite (mindestens) ein induktives Element 252 sitzt. Dieses induktive Element 252 ist als Printspule ausgebildet und dementsprechend flach ausgebildet. (In Figur 22 ist die Höhe des induktiven Elements 252 aus darstellerischen Gründen übertrieben.)

An der gegenüberliegenden Seite des Trägers 250 sind elektronische Bauelemente 254 angeordnet. Beispielsweise ist ein Chip an dem Träger 250 positioniert.

Weiterhin ist an dem Träger 250 ein Steckerelement 256 angeordnet, welches Kontaktstifte 258 aufweist. Über Kontaktelemente 260 sitzt das Steckerelement 256 starr an dem Träger 250, wobei die Kontaktelemente 260 auch für die elektrische Verbindung zwischen den Kontaktstiften 258 und dem Träger 250 sorgen.

Die Sensorvorrichtung 248 lässt sich mit geringer Höhe ausbilden.

Erfindungsgemäß werden Sensorvorrichtungen mit Sensormodulen zur Verbindung mit Haltemodulen oder mit eigenständigen Sensoreinheiten bereitgestellt. Bei der Sensormodul-Haltemodul-Kombination lässt sich eine Anpassung an eine Vielzahl von Anwendungen durchführen, ohne dass das Sensormodul variiert werden muss. Dadurch ergibt sich eine leichte Herstellbarkeit für das oder die Sensormodule mit einer Vielzahl von Anpassungsmöglichkeiten.

## Patentansprüche

1. Sensorvorrichtung, umfassend:
- ein Sensormodul (46) mit einem Gehäuse (12), mit mindestens einem Sensorelement (14), welches in dem Gehäuse (12) angeordnet ist, mit mindestens einer aktiven Sensorfläche (44) und mit einer Sensormodul-Anschlusseinrichtung (56); und
- ein Haltemodul (76) zum Halten des Sensormoduls (46), mit einer Haltemodul-Anschlusseinrichtung (80), welche an die Sensormodul-Anschlusseinrichtung (46) angepasst ist;
wobei über die Sensormodul-Anschlusseinrichtung (56) und die Haltemodul-Anschlusseinrichtung (80) das Sensormodul (46) an dem Haltemodul (76) fixierbar ist und eine elektrische Verbindung zwischen dem Sensormodul (46) und dem Haltemodul (76) bereitstellbar ist, und wobei das Haltemodul (76) zur Fixierung an einer Anwendung vorgesehen ist oder Teil einer Anwendung ist, die Energieversorgung des Sensormoduls (46) über das Haltemodul (76) erfolgt und die Signalauskopplung über das Haltemodul (76) erfolgt.

2. Sensorvorrichtung nach Anspruch 1, **dadurch gekennzeichnet, dass** die Sensormodul-Anschlusseinrichtung (56) und die Haltemodul-Anschlusseinrichtung (80) so ausgebildet sind, dass das Sensormodul (46) auf das Haltemodul (76) aufsteckbar ist.

3. Sensorvorrichtung nach Anspruch 1 oder 2, **dadurch gekennzeichnet, dass** die Sensormodul-Anschlusseinrichtung (46) mindestens einen Stift (58) aufweist und die Haltemodul-Anschlusseinrichtung (80) eine angepasste Stiftaufnahme (82) aufweist.

4. Sensorvorrichtung nach einem der vorangehenden Ansprüche, **dadurch gekennzeichnet, dass** die Haltemodul-Anschlusseinrichtung mindestens einen Stift aufweist und die Sensormodul-Anschlusseinrichtung mindestens eine angepasste Stiftaufnahme aufweist.

5. Sensorvorrichtung nach Anspruch 3 oder 4, **dadurch gekennzeichnet, dass** der mindestens eine Stift als Kontaktstift (58) ausgebildet ist.

6. Sensorvorrichtung nach einem der Ansprüche 3 bis 5, **dadurch gekennzeichnet, dass** mindestens zwei Stifte (58) vorgesehen sind.

7. Sensorvorrichtung nach einem der vorangehenden Ansprüche, **dadurch gekennzeichnet, dass** das Haltemodul (76) eine Montageeinrichtung (90) zur Fixierung an einer Anwendung aufweist.

8. Sensorvorrichtung nach Anspruch 7, **dadurch gekennzeichnet, dass** die Montageeinrichtung mindestens eine durchgehende Ausnehmung (110; 126) umfasst.

9. Sensorvorrichtung nach Anspruch 8, **dadurch gekennzeichnet, dass** eine Orientierungsrichtung der mindestens einen Ausnehmung (110) parallel zu einer Aufsteckrichtung (118) des Sensormoduls (46) auf das Haltemodul (106) ist.

10. Sensorvorrichtung nach Anspruch 8 oder 9, **dadurch gekennzeichnet, dass** eine Orientierungsrichtung der mindestens einen Ausnehmung (126) quer zu einer Aufsteckrichtung (130) des Sensormoduls (46) auf das Haltemodul (122) ist.

11. Sensorvorrichtung nach einem der Ansprüche 7 bis 10, **dadurch gekennzeichnet, dass** die Montageeinrichtung ein Gewinde (164) umfasst.

12. Sensorvorrichtung nach einem der Ansprüche 7 bis 11, **dadurch gekennzeichnet, dass** die Montageeinrichtung ein klemmbares Element und/oder mindestens ein klemmendes Element umfasst.

13. Sensorvorrichtung nach einem der Ansprüche 7 bis 12, **dadurch gekennzeichnet, dass** die Montageeinrichtung eine Stange (154) umfasst.

14. Sensorvorrichtung nach einem der vorangehenden Ansprüche, **dadurch gekennzeichnet, dass** das Haltemodul (142) mehrteilig ausgebildet ist,
wobei ein erstes Teil (144) an einer Anwendung fixierbar ist und ein zweites Teil (148) an dem ersten Teil (144) fixierbar ist.

15. Sensorvorrichtung nach einem der vorangehenden Ansprüche, **dadurch gekennzeichnet, dass** die mindestens eine aktive Sensorfläche (44) parallel zu einer Montageseite (120) des Haltemoduls (106) ist.

16. Sensorvorrichtung nach einem der Ansprüche 1 bis 14, **dadurch gekennzeichnet, dass** die mindestens eine aktive Sensorfläche (44) quer zu einer Montageseite des Haltemoduls (122) ist.

17. Sensorvorrichtung nach einem der vorangehenden Ansprüche, **dadurch gekennzeichnet, dass** eine Aufsteckrichtung (118) des Sensormoduls (46) auf das Haltemodul (106) quer zu einer Montageseite (120) des Haltemoduls (106) an einer Anwendung ist.

18. Sensorvorrichtung nach einem der Ansprüche 1 bis 16, **dadurch gekennzeichnet, dass** eine Aufsteckrichtung (130) des Sensormoduls (46) auf das Haltemodul (122) parallel zu einer Montageseite des Haltemoduls (102) an einer Anwendung ist.

19. Sensorvorrichtung nach einem der vorangehenden Ansprüche, **dadurch gekennzeichnet, dass** das Haltemodul (180) und das Sensormodul (46) so ausgebildet sind, dass das Sensormodul (46), wenn es an dem Haltemodul (180) gehalten ist, über eine Oberfläche des Haltemoduls (180) hinausragt.

20. Sensorvorrichtung nach einem der Ansprüche 1 bis 18, **dadurch gekennzeichnet, dass** das Haltemodul (190) und das Sensormodul (46) so ausgebildet sind, dass das Sensormodul (46), wenn es an dem Haltemodul (190) gehalten ist, mit einer Oberfläche des Haltemoduls (190) bündig ist oder gegen diese zurückgesetzt ist.

21. Sensorvorrichtung nach einem der vorangehenden Ansprüche, **dadurch gekennzeichnet, dass** das Haltemodul (106) einen Signalanschluss und elektrischen Anschluss aufweist.

22. Sensorvorrichtung nach Anspruch 21, **dadurch gekennzeichnet, dass** von dem Haltemodul (106) ein Kabel (116) weggeführt ist.

23. Sensorvorrichtung nach einem der vorangehenden Ansprüche, **dadurch gekennzeichnet, dass** das Haltemodul (96) eine Platine (98) ist.

24. Sensorvorrichtung nach einem der vorangehenden Ansprüche, **dadurch gekennzeichnet, dass** das Gehäuse (12) des Sensormoduls (46) eine Höhe (H) aufweist, welche höchstens zweifach so groß ist wie der größte Durchmesser (D) senkrecht zu der Höhe (H).

25. Sensorvorrichtung nach einem der vorangehenden Ansprüche, **dadurch gekennzeichnet, dass** das Gehäuse (12) des Sensormoduls (46) zylindrisch oder quaderförmig ist.

26. Sensorvorrichtung nach einem der vorangehenden Ansprüche, **dadurch gekennzeichnet, dass** die mindestens eine aktive Sensorfläche (44) durch eine Gehäuseseite des Sensormoduls (46) bestimmt ist.

27. Sensorvorrichtung nach Anspruch 26, **dadurch gekennzeichnet, dass** die mindestens eine aktive Sensorfläche (46) durch eine der Sensormodul-Anschlusseinrichtung (56) gegenüberliegende Gehäuseseite (50) bestimmt ist.

28. Sensorvorrichtung nach Anspruch 26, **dadurch gekennzeichnet, dass** die mindestens eine aktive Sensorfläche (74) quer zu einer Gehäuseseite liegt, an welcher die Sensormodul-Anschlusseinrichtung angeordnet ist.

29. Sensorvorrichtung nach einem der vorangehenden Ansprüche, **dadurch gekennzeichnet, dass** das mindestens eine Sensorelement (14) ein induktives Sensorelement oder kapazitives Sensorelement ist.

30. Sensorvorrichtung nach Anspruch 29, **dadurch gekennzeichnet, dass** das mindestens eine Sensorelement (14) eine Spule ist, welcher ein Spulenkern (28) zugeordnet ist.

31. Sensorvorrichtung nach einem der vorangehenden Ansprüche, **gekennzeichnet durch** eine Ausbildung als Abstandssensorvorrichtung oder Positionssensorvorrichtung oder Näherungssensorvorrichtung oder Tastervorrichtung.

32. Sensorvorrichtung nach einem der vorangehenden Ansprüche, **dadurch gekennzeichnet, dass** das Sensormodul (46) einen Träger (26) aufweist, welcher im wesentlichen parallel zum mindestens einen Sensorelement (14) orientiert ist.

33. Sensorvorrichtung nach Anspruch 32, **dadurch gekennzeichnet, dass** das mindestens eine Sensorelement (14) auf den Träger (26) aufgesteckt oder aufgelötet oder aufgedruckt ist.

34. Sensorvorrichtung nach Anspruch 32 oder 33, **dadurch gekennzeichnet, dass** zwischen dem mindestens einen Sensorelement (14) und dem Träger (26) ein Zwischenraum (30) gebildet ist.

35. Sensorvorrichtung nach Anspruch 34, **dadurch gekennzeichnet, dass** in dem Zwischenraum (30) ein oder mehrere elektronische Bauteile (36) angeordnet sind.

36. Sensorvorrichtung nach einem der Ansprüche 32 bis 35, **dadurch gekennzeichnet, dass** der Träger (26) parallel zu einer Gehäuseseite (16; 18) des Gehäuses (12) des Sensormoduls (46) angeordnet ist.

37. Sensorvorrichtung nach einem der Ansprüche 32 bis 36, **dadurch gekennzeichnet, dass** der Träger (26) parallel zu einer aktiven Sensorfläche (44) angeordnet ist.

38. Sensorvorrichtung nach einem der Ansprüche 24 bis 37, **dadurch gekennzeichnet, dass** an einem Träger und/oder an dem Gehäuse (12) Kontaktstifte angeordnet sind.

39. Induktive Sensorvorrichtung mit einer Sensoreinheit (11), umfassend eine Spule als Sensorelement (14) und ein Gehäuse (12), in welchem die Spule angeordnet ist, wobei das Gehäuse (12) eine erste Gehäusestirnseite (16) aufweist, durch welche eine aktive Sensorfläche (44) bestimmt ist, und eine gegenüberliegende zweite Gehäusestirnseite (18) aufweist,
**dadurch gekennzeichnet , dass** ein Signalanschluss und ein Energieversorgungsanschluss an einer Gehäuseseitenseite (22) zwischen der ersten Gehäusestirnseite (16) und der zweiten Gehäusestirnseite (18) angeordnet ist.

40. Induktive Sensorvorrichtung nach Anspruch 39, **dadurch gekennzeichnet, dass** das Gehäuse (12) geschlossen ist.

41. Induktive Sensorvorrichtung nach Anspruch 39 oder 40, **dadurch gekennzeichnet, dass** ein Kabel (42) an die Gehäuseseitenseite (22) angeschlossen ist.

42. Induktive Sensorvorrichtung nach einem der Ansprüche 39 bis 41, **dadurch gekennzeichnet, dass** das Gehäuse (12) eine Höhe (H) aufweist, welche höchstens zweifach so groß ist wie der größte Durchmesser (D) des Gehäuses (12) senkrecht zu der Höhe (H).

43. Induktive Sensorvorrichtung nach einem der Ansprüche 39 bis 42, **dadurch gekennzeichnet, dass** das Gehäuse (12) zylindrisch oder quaderförmig ist.

44. Induktive Sensorvorrichtung nach einem der Ansprüche 39 bis 43, **dadurch gekennzeichnet, dass** der Spule ein Spulenkern (28) zugeordnet ist.

45. Induktive Sensorvorrichtung nach einem der Ansprüche 39 bis 44, **dadurch gekennzeichnet, dass** ein Träger (26) im Gehäuse (12) angeordnet ist, welcher im wesentlichen parallel zu der ersten Gehäusestirnseite (16) orientiert ist.

46. Induktive Sensorvorrichtung nach Anspruch 45, **dadurch gekennzeichnet, dass** die Spule auf den Träger (26) aufgesteckt oder aufgelötet oder aufgedruckt ist.

47. Induktive Sensorvorrichtung nach Anspruch 45 oder 46, **dadurch gekennzeichnet, dass** zwischen der Spule und dem Träger (26) ein Zwischenraum (30) gebildet ist.

48. Induktive Sensorvorrichtung nach Anspruch 47, **dadurch gekennzeichnet, dass** in dem Zwischenraum (30) ein oder mehrere elektronische Bauteile (36) angeordnet sind.

49. Induktive Sensorvorrichtung nach einem der Ansprüche 45 bis 48, **dadurch gekennzeichnet, dass** der Träger (26) parallel zu der ersten Gehäusestirnseite (16) orientiert ist.

50. Induktive Sensorvorrichtung nach einem der Ansprüche 39 bis 49, **gekennzeichnet durch** einen Halter (222), welcher an einer Anwendung fixierbar ist, wobei das Gehäuse (12) an dem Halter (222) fixierbar ist.

51. Induktive Sensorvorrichtung nach Anspruch 50,**dadurch gekennzeichnet, dass** der Halter (222) einen Aufnahmeraum (226) für das Gehäuse (12) aufweist.

52. Induktive Sensorvorrichtung mit einer Sensoreinheit (11), umfassend ein Gehäuse (12) und mindestens ein induktives Sensorelement (14), welches in dem Gehäuse (12) angeordnet ist,
**dadurch gekennzeichnet , dass** das Gehäuse (12) eine Höhe (H) aufweist, welche höchstens zweifach so groß ist wie der größte Durchmesser (D) senkrecht zu der Höhe (H).

53. Induktive Sensorvorrichtung nach Anspruch 52, **dadurch gekennzeichnet, dass** das Gehäuse (12) zylindrisch oder quaderförmig ist.

54. Induktive Sensorvorrichtung nach Anspruch 52 oder 53, **dadurch gekennzeichnet, dass** eine aktive Sensorfläche (44) durch eine Gehäuseseite (16) bestimmt ist.

55. Induktive Sensorvorrichtung nach einem der Ansprüche 52 bis 54, **dadurch gekennzeichnet, dass** dem mindestens einen induktiven Sensorelement ein Spulenkern (28) zugeordnet ist.

56. Induktive Sensorvorrichtung nach einem der Ansprüche 52 bis 55, **gekennzeichnet durch** eine Ausbildung als Abstandssensorvorrichtung oder Positionssensorvorrichtung oder Näherungssensorvorrichtung oder Tastervorrichtung.

57. Induktive Sensorvorrichtung nach einem der Ansprüche 52 bis 56, **dadurch gekennzeichnet, dass** ein Träger (26) vorgesehen ist, welcher im wesentlichen parallel zum mindestens einen induktiven Sensorelement (14) orientiert ist.

58. Induktive Sensorvorrichtung nach Anspruch 57, **dadurch gekennzeichnet, dass** das mindestens eine induktive Sensorelement (14) auf den Träger (26) aufgesteckt oder aufgelötet oder aufgedruckt ist.

59. Induktive Sensorvorrichtung nach Anspruch 57 oder 58, **dadurch gekennzeichnet, dass** zwischen dem mindestens einen induktiven Sensorelement (14) und dem Träger (26) ein Zwischenraum (30) gebildet ist.

60. Induktive Sensorvorrichtung nach Anspruch 59, **dadurch gekennzeichnet, dass** in dem Zwischenraum (30) ein oder mehrere elektronische Bauteile (36) angeordnet sind.

61. Induktive Sensorvorrichtung nach einem der Ansprüche 57 bis 60, **dadurch gekennzeichnet, dass** der Träger (26) parallel zu einer Gehäuseseite (16) des Gehäuses (12) angeordnet ist.

62. Induktive Sensorvorrichtung nach einem der Ansprüche 57 bis 61, **dadurch gekennzeichnet, dass** der Träger (26) parallel zu einer aktiven Sensorfläche (44) angeordnet ist.

63. Induktive Sensorvorrichtung nach einem der Ansprüche 52 bis 62, **dadurch gekennzeichnet, dass** an einem Träger und/oder an dem Gehäuse (12) Kontaktstifte angeordnet sind.

64. Induktive Sensorvorrichtung nach einem der Ansprüche 57 bis 62, **dadurch gekennzeichnet, dass** an dem Träger (238) ein Steckerelement (242) angeordnet ist.

65. Induktive Sensorvorrichtung nach Anspruch 64, **dadurch gekennzeichnet, dass** das Steckerelement (242) starr mit dem Träger (238) verbunden ist.

66. Induktive Sensorvorrichtung nach Anspruch 64 oder 65, **dadurch gekennzeichnet, dass** das Steckerelement (242) Kontaktstifte (258) aufweist.

67. Induktive Sensorvorrichtung nach einem der Ansprüche 52 bis 66, **dadurch gekennzeichnet, dass** das mindestens eine induktive Element (252) auf einer Seite des Trägers (250) angeordnet ist und elektronische Bauteile (254) auf der gegenüberliegenden Seite des Trägers (250) angeordnet sind.
